# EUROPEAN PATENT SPECIFICATION

(11) **EP 0 898 811 B1**
(45) Date of publication and mention of the grant of the patent: **26.09.2001**
(21) Application number: 97921962.3
(22) Date of filing: 14.05.1997
(51) Int. Cl.: H03K 17/0812, H03K 17/082, H03K 17/10, H03K 17/567

(54) **INSULATED GATE BIPOLAR TRANSISTOR CONTROL**
ANSTEUERSCHALTUNG FÜR EINEN BIPOLARTRANSISTOR MIT ISOLIERTEM GATE
COMMANDE DE TRANSISTOR BIPOLAIRE A GRILLE ISOLEE

(30) Priority: 15.05.1996 GB 9610098
(43) Date of publication of application: 03.03.1999
(73) Proprietor: CAMBRIDGE UNIVERSITY TECHNICAL SERVICES LIMITED, Cambridge CB2 1TS (GB)
(72) Inventor: PALMER, Patrick, Reginald, Cambridge CB4 4HY (GB); LEEDHAM, Robert, John, Cambridge CB1 3AL (GB); GITHIARI, Anthony, Njdroge, Cambridge CB3 9BB (GB)
(74) Representative: Haley, Stephen
(86) International application number: GB9701310
(87) International publication number: WO9743832

(56) References cited:
- EP-A- 0 555 047
- EP-A- 0 568 353
- FR-A- 2 394 930
- US-A- 4 591 734
- RECORD OF THE INDUSTRY APPLICATIONS CONFERENCE (IAS), ORLANDO, OCT. 8 - 12, 1995, vol. 3, 8 October 1995, INSTITUTE OF ELECTRICAL AND ELECTRONICS ENGINEERS, pages 2752-2758, XP000547184 CONSOLI A ET AL: "ACTIVE VOLTAGE BALANCEMENT OF SERIES CONNECTED IGBTS"
- PROCEEDINGS OF THE ANNUAL APPLIED POWER ELECTRONICS CONFERENCE AND EXPOSITION (APEC), ORLANDO, FEB. 13 - 17, 1994, vol. 1, 13 February 1994, INSTITUTE OF ELECTRICAL AND ELECTRONICS ENGINEERS, pages 469-472, XP000467353 GERSTER C: "FAST HIGH-POWER/HIGH-VOLTAGE SWITCH USING SERIES-CONNECTED IGBTS WITH ACTIVE GATE-CONTROLLED VOLTAGE-BALANCING"
- RECORD OF THE ANNUAL POWER ELECTRONICS SPECIALISTS CONFERENCE (PESC, ATLANTA, JUNE 12 - 15, 1995, vol. 1, 12 June 1995, INSTITUTE OF ELECTRICAL AND ELECTRONICS ENGINEERS, pages 44-49, XP000548384 PALMER P R ET AL: "THE SERIES CONNECTION OF IGBTS WITH OPTIMISED VOLTAGE SHARING IN THE TRANSIENT"
- CONFERENCE RECORD OF THE INDUSTRY APPLICATIONS CONFERENCE, DENVER, OCT. 2 - 5, 1994, vol. 2, 2 October 1994, INSTITUTE OF ELECTRICAL AND ELECTRONICS ENGINEERS, pages 795-804, XP000512467 BLAABJERG F ET AL: "OPTIMUM DESIGN AND TEST OF A SNUBBERLESS IGBT PWM-VSI INVERTERBRIDGE"

## Description

This invention relates to the control of insulated gate bipolar transistors (IGBTs).

IGBTs are devices which enable the control of large currents by the application of low level voltages or currents, so that electronic devices, such as microprocessors, can control electrical equipment such as motors which require large currents and/or high voltages.

In recent years there have been considerable improvements in the manufacture of IGBTs, which means that reliable devices that have ratings of up to 1600V and 1200A are now available. Such devices do, however, have problems associated with them. one particular problem is during switch-off of the devices. During switch-off it is difficult to control the rate of change of voltage across the IGBT over time, leading to the creation of electromagnetic interference problems and overshoot voltages which are difficult to overcome.

Furthermore, there are many applications in which it is desirable to control higher voltages by placing such IGBTs in series connection. Series connection of IGBTs is still, however, difficult to perform reliably and cost effectively. Variations in the manufacturing tolerances of IGBTs means that individual IGBTs can have significantly variable switch off times and varying voltage and current characteristics. This means that, when such IGBTs are connected in series, switching the devices off becomes difficult, as certain IGBTs will switch off before other IGBTs, leading to the creation of destructive current flow or destructive voltage differences across individual devices.

Attempts have been made to overcome this problem by the use of snubber circuits to delay the switching of individual devices, but such snubber circuits increase the overall switching time of the series arrangement and, of increasing the overall size and cost of the circuitry.

Accordingly, the present invention is directed towards providing a method and circuit for controlling IGBTs, both individually and in series, which overcomes the above problems.

P.R. Palmer and A.N. Githiari : "The Series Connection of IGBT's with Optimised Voltage Sharing in the Switching Transient", Record of the Annual Power Electronics Specialists Conference (PESC), Atlanta, June 12-15, 1995, IEEE, June 12, 1995, vol. 1, pages 44-49 and A.R. Hefner : "An Investigation of the Drive Circuit Requirements for the Power Insulated Gate Bipolar Transistor (IGBT)", IEEE Transactions on Power Electronics, vol. 6, no. 2, April 1991 disclose methods and circuits for switching series connected IGBT's.

FR-A-2394930 discloses a method and circuit for controlling a bipolar transistor.

According to the present invention there is provided a method of controlling the switch-off of an insulated gate bipolar transistor (IGBT), the method comprising the steps of:
applying, upon receipt of a switch-off signal, a voltage to the gate at a level which maintains the current flowing through the IGBT whilst allowing the voltage across the IGBT to increase to a predetermined plateau level; and
after a predetermined time period, applying a voltage function to the gate of the IGBT to turn the IGBT off.

The gate voltage required to maintain the voltage across the IGBT at the plateau voltage level may be determined by the use of closed loop feedback monitoring.

The voltage function which is applied to the gate of the IGBT to turn the IGBT off can be altered to ensure that optimum switch-off characteristics are achieved for the particular type of IGBT that is being controlled.

By selecting the duration of the predetermined time period, and the value of the plateau voltage, the later rate of change of voltage across the device in relation to time can be accurately controlled to ensure that it does not exceed the required limits. Furthermore, the method of the present invention ensures that the overall power consumed by the IGBT during switch-off can be controlled and reduced, leading to more efficient switching.

If plural series connected IGBTs are each controlled in accordance with the above method, with the provision of a predetermined period in which the voltage across each of the individual IGBTs is maintained at the plateau voltage, the effects of the delays associated with individual IGBT gates are reduced. Furthermore, the provision of this predetermined period ensures that each IGBT enters its active region, at a similar time. With the collector voltage increasing to the plateau voltage, there is also a marked reduction in gate collector capacitance, and the adverse internal effects generated in the IGBT during switch-off have time to settle.

According to the present invention there is also provided a circuit for controlling the switch-off of a insulated gate bipolar transistor (IGBT), the circuit comprising:
a gate drive circuit and characterised by: the gate drive circuit being arranged to provide a gate drive voltage to the gate of the IGBT;
a control signal generating circuit, connected to the gate drive circuit, for generating a first stage of a control signal, produced upon receipt of a switch-off signal, for controlling the gate drive circuit to drive the gate voltage of the IGBT to a level at which the voltage across the IGBT is set to and maintained at a predetermined plateau voltage, and a second stage of the control signal for controlling the gate drive circuit to switch the IGBT off, said second stage being generated a predetermined time period after generation of the first stage.

The control signal generating circuit may incorporate a closed loop voltage monitoring circuit.

One example of the present invention will now be described with reference to the accompanying drawings, in which:
Figure 1 is a circuit diagram showing a circuit according to the present invention;
Figure 2 is a circuit diagram showing additional feedback circuitry that may be provided with the circuit of Figure 1;
Figure 3 is a diagram showing the gate voltage generated by the circuitry of Figures 1 and 2 along with the switching waveforms, the time axes of the waveforms are not drawn to the same scale;
Figures 4a to 4c disclose the first semiconductor device adapted specifically to employ the method of the present invention; and
Figures 5a to 5c show a second semiconductor device adapted to employ the method of the present invention also.

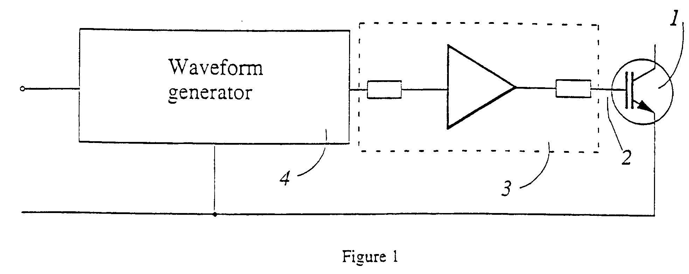

Referring to Figure 1, an IGBT 1 is connected to drive a load under the influence of control circuitry (not shown). Connected to the gate 2 of the IGBT 1 is a gate drive circuit 3 which effectively acts as a buffer circuit for a control signal generating circuit 4. The gate drive circuit 3 can be formed in a known manner by employing an operational amplifier and resistors in the manner shown, although it will be appreciated that alternative circuit arrangements which perform the same function are possible.

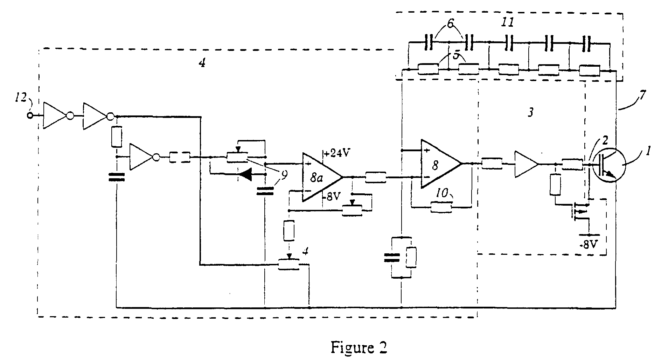

Figure 2 shows the circuitry of Figure 1 with the addition of a closed loop voltage monitoring circuit 11 with an IGBT 1. The additional voltage monitoring circuitry 11 is here provided to create the control signal in a closed loop manner for the IGBT control. In this circuit, a feedback loop consisting of an array of resistors 5 and capacitors 6, which is attached to the collector 7 of the IGBT 1 and the positive input of an operational amplifier 8, is provided. The negative input of the operational amplifier 8 is connected to its output by a feedback resistor 10 and is also connected to the output of the remainder of the reference waveform generator circuit 4 from Figure 1. Again, it will be appreciated that the voltage monitoring circuit 11 could be realised using equivalent circuitry employing alternative components. It will also be appreciated that the waveform generated for closed loop control will be different from that for open-loop control (Figure 1).

The control signal generating circuit 4 comprises an operational amplifier 8a. The reference voltage level at the positive input of the operational amplifier 8a is set by a resistor and capacitor arrangement 9. The negative input of the operational amplifier 8a is connected to a further section of the control signal generating circuit 4, which provides a series of control signals to the operational amplifier 8a, leading to the operational amplifier 8 generating signals for controlling the gate drive circuitry 3 in a manner described below. This arrangement is effectively providing control of the IGBT by generating demand voltages to be applied to the feedback loop around the IGBT 1.

The remainder of the control circuit 4 has an input 12 connected to control circuitry or a microprocessor (not shown). This section of the control circuit 4 is arranged to produce required signals from a control signal input in a manner described below. Again, this circuit could comprise alternative components that perform a similar function.

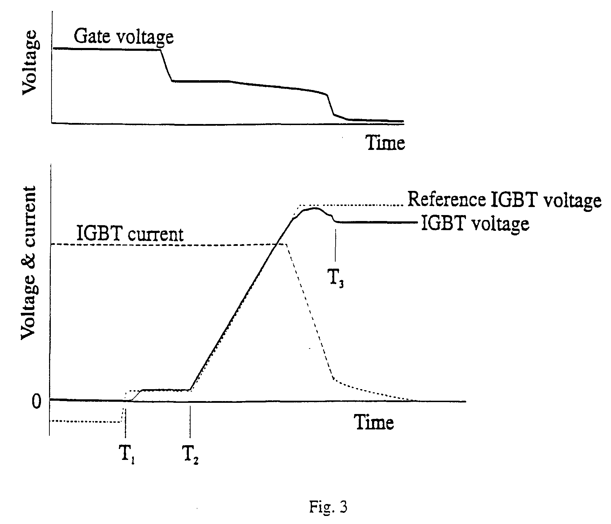

Referring to Figure 3, the gate voltage, together with the voltage across the IGBT 1, the reference IGBT voltage and the current flowing through the IGBT are shown in relation to time for the circuit of Figure 2. At a time zero, the IGBT is on and has a low voltage across it, with full current flow. To ensure full current flow, the gate voltage is driven positive. At time T1, the control circuitry (not shown) determines that the IGBT 1 is to be turned off, and a signal is provided via circuit 4, to gate drive circuit 3 which drives the gate voltage to a slightly lower positive value. Because of the effect of the circuits 4, 3 and 11, the current through the IGBT is maintained at the same value, and a plateau voltage is reached, the plateau enables settling of the device, giving the advantages described above, for complete turnoff. At time T2, circuit 4 via circuit 3 controls the gate voltage, driving it downward and starting complete turnoff of the IGBT 1. In Figure 3, a truncated ramp function reference IGBT voltage is used, although other functions, which provide optimum performance for the particular type of IGBT being employed, can be applied. The current starts to decay until the IGBT 1 is turned off at a time T3, at which time the voltage across the IGBT 1 starts to float.

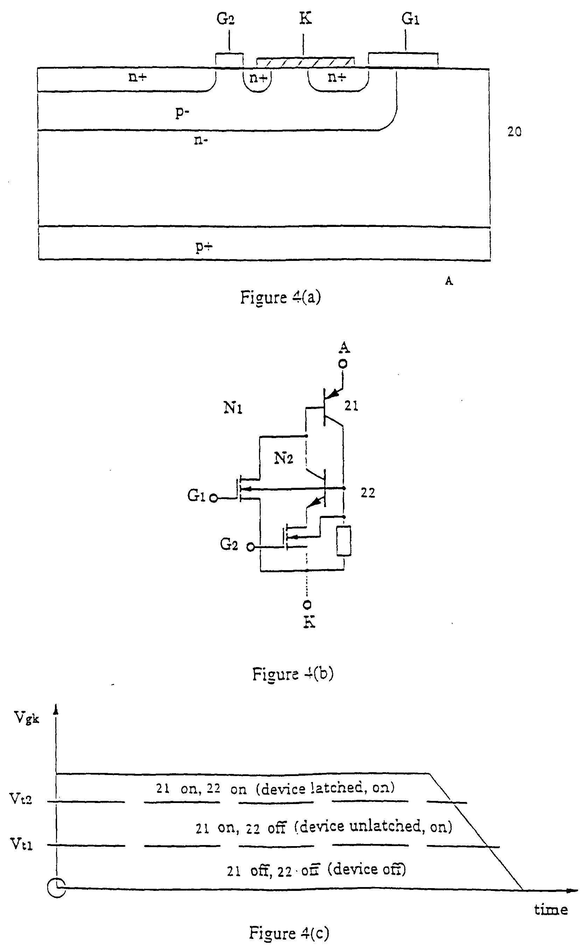

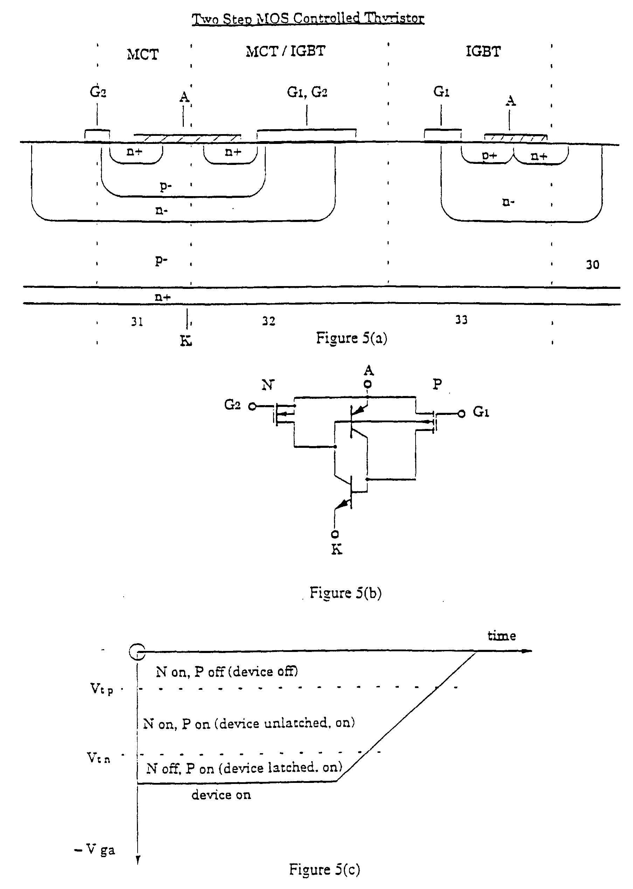

Figures 4a to 4c and 5a to 5c show semiconductor devices and their equivalent schematic diagrams and turnoff waveforms that can be arranged to perform the method of the present invention without the need for a large amount of control circuitry or gate drive circuitry.

Referring to Figure 4a, an emitter switched thyristor is formed from four layers of alternately doped semiconductor material and has two gates G₁ and G₂ for controlling its switching. As can be seem from Figure 4b, the device is effectively equivalent to a standard insulated gate bipolar transistor with two bipolar junctions 21, 22, but with an additional gate G₂. The gates, which are both metal oxide layers, are arranged so that they have differing threshold voltages, with the gate G₂, having a higher gate threshold voltage than gate G₁. In operation, if the two gates G₁, G₂, are connected, and a slowly decreasing voltage function applied across the gates and point K, because of the differing threshold voltages, gate G₂ switches off first, driving the device to create a plateau voltage across it. As the gate voltage decreases further, gate G₁ finally switches off to turn the device off completely.

Referring to Figures 5a to 5c, a MOS controlled thyristor 30 is shown. This device 30 is formed from five layers of semiconductor material and, again, has two gates G₁ and G₂. Forming a depletion mode device N is useful in that negative threshold voltages can be used with NMOS , as shown in Figure 5c. As can be seen from Figure 5a, this device is effectively three devices, a MOS controlled thryistor 31, a MOS controlled thyristor/IGBT device 32, and an IGBT 33. As can be seem from Figure 5b, this device has advantages over the device of Figures 4a to 4c in that it has no MOS device in the current path, meaning that it has a lower voltage across it when switched on. As with the device of Figures 4a to 4c, the two gates G₁, G₂ are arranged to have differing threshold voltages, so that when they are connected to each other in use, one switches off before the other, enabling a two-step switch off in accordance with the method of the present invention. It will be appreciated that complementary devices, and alternative configurations having the same function as those of Figures 4a and 5a, could also be produced to perform the method of the invention.

## Claims

1. A method of controlling the switch-off of an insulated gate bipolar transistor (IGBT) (1), the method comprising the steps of:
applying, upon receipt of a switch-off signal, a voltage to the gate at a level which maintains the current flowing through the IGBT whilst allowing the voltage across the IGBT to increase to a predetermined plateau level; and
after a predetermined time period, applying a voltage function to the gate (2) of the IGBT to turn the IGBT off.

2. A method according to claim 1, wherein the gate voltage required to maintain the voltage across the IGBT (1) at the plateau voltage level is determined by the use of closed loop feedback monitoring.

3. A method according to claim 1 or claim 2, wherein the voltage function which is applied to the gate (2) of the IGBT (1) to turn the IGBT off is adjusted to ensure that optimum switch-off characteristics are achieved.

4. A device for use in the method of claims 1 to 3 **characterised by**:
two gates (G₁, G₂), each connected to the other and having differing threshold voltages.

5. A circuit for controlling the switch-off of a insulated gate bipolar transistor (IGBT) (1) or a device according to claim 4, the circuit comprising:
a gate drive circuit (3) and **characterised by**: the gate drive circuit being arranged to provide a gate drive voltage to the gate of the IGBT;
a control signal generating circuit (4), connected to the gate drive circuit, for generating a first stage of a control signal, produced upon receipt of a switch-off signal, for controlling the gate drive circuit to drive the gate voltage of the IGBT to a level at which the voltage across the IGBT is set to and maintained at a predetermined plateau voltage, and a second stage of the control signal for controlling the gate drive circuit to switch the IGBT off, said second stage being generated a predetermined time period after generation of the first stage.

6. A circuit according to claim 5, wherein the control signal generating circuit (4) incorporates a closed loop voltage monitoring circuit.

## Patentansprüche

1. Verfahren zur Steuerung des Ausschaltens eines Bipolartransistors mit isoliertem Gate (IGBT) (1), welches die folgenden Schritte aufweist:
ansprechend auf ein empfangenes Ausschaltsignal wird eine Spannung an das Gate in einer Stärke angelegt, die den Stromfluß durch das IGBT aufrechterhält, während die Spannung an dem IGBT auf einen vorbestimmten Plateauwert steigen kann, und
nach einer vorbestimmten Zeitdauer wird eine Spannungsfunktion an das Gate (2) des IGBTs angelegt, um den IGBT auszuschalten.

2. Verfahren nach Anspruch 1, **dadurch gekennzeichnet, daß** die Gatespannung, die zur Aufrechterhaltung der Spannung an dem IGBT (1) auf den Plateauspannungswert erforderlich ist, mit einer rückgekoppelten Überwachung bestimmt wird.

3. Verfahren nach Anspruch 1 und 2, **dadurch gekennzeichnet, daß** die an das Gate (2) des IGBT (1) angelegte Spannung zum Ausschalten des IGBTs angepaßt ist, um sicherzustellen, daß optimales Ausschaltverhalten erreicht wird.

4. Bauelement zur Verwendung bei dem Verfahren nach den Ansprüchen 1 bis 3, **dadurch gekennzeichnet, daß**:
Zwei Gates (G₁, G₂) miteinander verbunden sind und unterschiedliche Schwellenspannungen besitzen.

5. Schaltkreis zur Steuerung des Ausschaltens eines Bipolartransistors mit isoliertem Gate (IGBT) (1) oder eines Bauelements nach Anspruch 4, wobei der Schaltkreis folgendes aufweist:
einen Gateansteuerschaltkreis (3), **dadurch gekennzeichnet, daß** der Gateansteuerschaltkreis angeordnet ist, um eine Gateansteuerspannung für das Gate des IGBTs bereitzustellen,
einen Steuersignalerzeugungsschaltkreis (4), der mit dem Gateansteuerschaltkreis verbunden ist, um eine erste Stufe eines Steuersignals ansprechend auf ein empfangenes Ausschaltsignal zur Steuerung des Gateansteuerschaltkreises zu erzeugen, um die Gatespannung des IGBTs auf einem Niveau zu steuern, bei dem die Spannung an dem IGBT auf einen vorbestimmten Plateauspannungswert gesetzt ist und auf diesem gehalten wird, und um eine zweite Stufe des Steuersignals zur Steuerung des Gateansteuerschaltkreises zu erzeugen, um das IGBT auszuschalten, wobei die zweite Stufe nach einer vorbestimmten Zeitdauer nach Erzeugung der ersten Stufe erzeugt wird.

6. Schaltkreis nach Anspruch 5, **dadurch gekennzeichnet, daß** der Steuersignalerzeugungsschaltkreis (4) einen rückgekoppelten Spannungsüberwachungsschaltkreis aufweist.

## Revendications

1. Procédé de commande de la coupure d'un transistor bipolaire à grille isolée (IGBT) (1), le procédé comprenant les étapes de :
application, suite à la réception d'un signal de coupure, d'une tension sur la grille à un niveau qui maintient le courant qui circule au travers de l'IGBT tout en permettant à la tension aux bornes de l'IGBT d'augmenter jusqu'à un niveau de plateau prédéterminé ; et
après une période temporelle prédéterminée, application d'une fonction de tension sur la grille (2) de l'IGBT afin de rendre l'IGBT bloqué.

2. Procédé selon la revendication 1, dans lequel la tension de grille requise pour maintenir la tension aux bornes de l'IGBT (1) au niveau de tension de plateau est déterminée par l'utilisation d'une surveillance de retour en boucle fermée.

3. Procédé selon la revendication 1 ou 2, dans lequel la fonction de tension qui est appliquée sur la grille (2) de l'IGBT (1) pour rendre l'IGBT bloqué est réglée afin d'assurer que des caractéristiques de coupure optimum sont réalisées.

4. Dispositif pour une utilisation selon le procédé des revendications 1 à 3, **caractérisé par** :
deux grilles (G₁, G₂) dont chacune est connectée à l'autre et qui présentent des tensions de seuil différentes.

5. Circuit pour commander la coupure d'un transistor bipolaire à grille isolée (IGBT) (1) ou d'un dispositif selon la revendication 4, le circuit comprenant :
un circuit de pilotage de grille (3) ; et
**caractérisé par** le fait que le circuit de pilotage de grille est agencé pour appliquer une tension de pilotage de grille sur la grille de l'IGBT ;
un circuit de génération de signal de commande (4), connecté au circuit de pilotage de grille, pour générer un premier niveau d'un signal de commande, produit suite à la réception d'un signal de coupure, pour commander le circuit de pilotage de grille afin de piloter la tension de grille de l'IGBT à un niveau auquel la tension aux bornes de l'IGBT est établie et maintenue à une tension de plateau prédéterminée et un second niveau du signal de commande pour commander le circuit de pilotage de grille pour couper l'IGBT, ledit second niveau étant généré une période temporelle prédéterminée après la génération du premier niveau.

6. Circuit selon la revendication 5, dans lequel le circuit de génération de signal de commande (4) incorpore un circuit de surveillance de tension en boucle fermée.
